# EUROPEAN PATENT SPECIFICATION

(11) **EP 3 136 117 B1**
(45) Date of publication and mention of the grant of the patent: **19.08.2020**
(21) Application number: 16186987.0
(22) Date of filing: 23.05.2013
(51) Int. Cl.: G06F 1/3212, H02J 7/00

(54) **LOW-POWER BATTERY MONITORING WITH SAFETY SYSTEM**
NIEDRIGENERGIE-BATTERIEPACK MIT SICHERHEITSSYSTEM
BLOC-BATTERIE À BASSE PUISSANCE COMPORTANT UN SYSTÈME DE SÉCURITÉ

(30) Priority: 24.05.2012 US 201261651376 P; 14.03.2013 US 201361782358 P
(43) Date of publication of application: 01.03.2017
(62) Divisional of application: 13726402.4
(73) Proprietor: HeartWare, Inc., Miami Lakes, FL 33014 (US)
(72) Inventor: EAGLE, Jonathan, Weston, MA 02493 (US); HARDY, Jon, Bellingham, MA 02019 (US)
(74) Representative: Zimmermann & Partner Patentanwälte mbB

(56) References cited:
- WO-A1-97/24652
- US-A1- 2008 111 520
- US-A1- 2010 085 016
- US-A1- 2011 119 005

## Description

### CROSS-REFERENCE TO RELATED APPLICATIONS

### BACKGROUND OF THE INVENTION

This invention generally pertains to a smart rechargeable battery pack with low power processor and a safety system to help provide for an extended shelf life.

Rechargeable batteries have become ubiquitous in today's world, being used in everything from cell phones and laptops to medical devices to airplanes. Often, it is desirable for a user to be kept apprised of how much charge is left in a battery powering a device. This may be especially true when devices are not used for an extended period of time, such as when they are being shipped or stored. However, monitoring the charge of a battery generally results in the charge being depleted.

Typically, the amount of power used to detect the remaining charge of a battery is small. For a device using a large battery pack, for example those rated greater than approximately 5 ampere-hours, the large battery pack may not be significantly drained from detecting the remaining charge. However, for a device that uses a small battery for general functioning, for example those rated at approximately 0.7 ampere-hours, the amount of power drawn by a circuit that monitors battery charge can result in a significant drain on the relatively small battery.

This problem is especially evident when the battery-powered device is not used for an extended period of time, such as when the device is being stored in inventory or shipped. As noted above, even though a device is not being used, power is being consumed from a battery pack to continually monitor the charge, inevitably leaving the battery drained. For devices in inventory, the need to recharge devices on a continual basis is expensive and work-intensive. For devices being shipped, recharging may be difficult, if not impossible.

Therefore, there is a need to provide a smart battery pack that includes a low power processor for monitoring the charge remaining on the battery pack. This would provide for better power management and increased battery life.

Document US 2008/0111520 A1 discloses a battery pack having a secondary battery; a measurement unit measuring a terminal voltage and a current of the secondary battery; a protection unit preventing the secondary battery from being overcharged when the terminal voltage measured by the measurement unit is equal to or higher than an overcharge detection voltage; and a control unit receiving the terminal voltage and current measured by the measurement unit, the control unit having a first mode and a second mode in which current is less consumed than the first mode.

US 2010/0085016 A1 discloses a method and apparatus for battery gauging in a portable terminal. In the battery gauging method, it is determined in a low-power mode whether a listening interval occurs for detecting the presence of a received signal. The remaining battery capacity is detected if the listening interval occurs. An interrupt signal is transmitted to the second processor, operating in a low-power mode, if the remaining battery capacity is less than or equal to a threshold. Upon receipt of the interrupt signal, the second processor wakes up to interrupt the power of the portable terminal.

### BRIEF SUMMARY OF THE INVENTION

The current application addresses the need in the art by providing a smart battery pack that includes a low power processor for tracking the charge of the battery pack and a safety system to provide power in case the low power processor fails.

According to one aspect of the present invention, there is a method for monitoring the charge of a battery, that comprises the steps of powering off a battery monitor circuit using a low power processor. The method also includes the step of the low power processor periodically enabling the battery monitor circuit to monitor the charge of the battery. If a fault occurs that prevents the low power processor from communicating with the battery monitor circuit, a digital processor located within the controller will communicate with the battery monitor circuit to track the charge of the battery.

According to another aspect of the present invention, there is a device with a system for monitoring the charge of a battery, comprising an internal battery with a low power processor, an external battery, a digital processor, and a safety override circuit that allows charge to flow when a fault occurs with the low power processor.

According to an aspect of the present invention there is provided a method for monitoring a charge of a battery in a device, comprising:
providing a low power processor having a wake state and a dormant state, the low power processor configured to periodically change from the dormant state to the wake state; and
periodically enabling a battery monitor circuit to determine the charge of the battery, the low power processor enabling the battery monitor circuit when the low power processor is in the wake state;
wherein the battery monitor circuit has a default safe state in which a digital processor enables the battery monitor circuit and a normal operating state in which the low power processor periodically enables the battery monitor circuit, the battery monitor circuit switching from the default safe state to the normal operating state when the low power processor is detected,
wherein the digital processor is different than the low power processor.

In certain embodiments, the battery monitor circuit may switch from the normal operating state to the default safe state when the device detects a fault in the low power processor.

Determining the charge of the battery may further comprise detecting the charge of at least two batteries. Optionally, at least one of the two batteries may be removable from the device.

In certain embodiments, the method may further comprise displaying the determined charge on a display on the device.

The method may further comprise generating an alarm when the determined charge is below a threshold.

The method may further comprise displaying a fault message if the low power processor fails to wake-up.

This invention results in a very low power smart battery with full gauging capability with a very long shelf life (typically, greater than 12 months). Additionally, the invention lowers the rate of device failure, despite additional hardware, by including an additional safety mechanism that will ensure that the battery monitor circuit continues to operate despite a fault that might arise from the addition of new hardware in the device.

### BRIEF DESCRIPTION OF THE DRAWINGS

Fig. 1 is a conventional diagram of a ventricular assist system.
Fig. 2 is an exemplary embodiment of the ventricular assist system with a smart battery and power monitoring circuitry.
Fig. 3 is a diagram of the safety override architecture.
Fig. 4 is a diagram of the simplified battery architecture.

### DETAILED DESCRIPTION

It will be appreciated by those skilled in the art that for the sake of brevity and clarity like reference numerals may be repeated where appropriate. Additionally, specific details are set forth to provide a better understanding of the embodiments described herein. However, a skilled artisan will understand that the present invention can be practiced without the specific details, and those details may be replaced by well-known and commonly practiced equivalents. Furthermore, this written description should not be construed as being limited to the scope of the embodiments described herein.

The embodiments below are discussed generally in terms of a ventricular assist system, specifically HeartWare™ Ventricular Assist System. Generally speaking, the HeartWare™ Ventricular Assist System includes a controller that is external to the patient. This external controller includes drive electronics for a pump implanted into a patient and configured to assist the heart in pumping blood. The external controller also provides drive and control signals to the pump and provides feedback and alarms to the patient regarding the operation of the device. Alarms are generated, for example, when the battery falls below a certain threshold and can be audio, visual, tactile, or a combination thereof. Similar controllers are described, for example, in U.S. Patent Application No. 61/749,038 to Vadala, titled "Controller and Power Source for Implantable Blood Pump," filed January 4, 2013, the entire contents of which are hereby incorporated by reference herein.

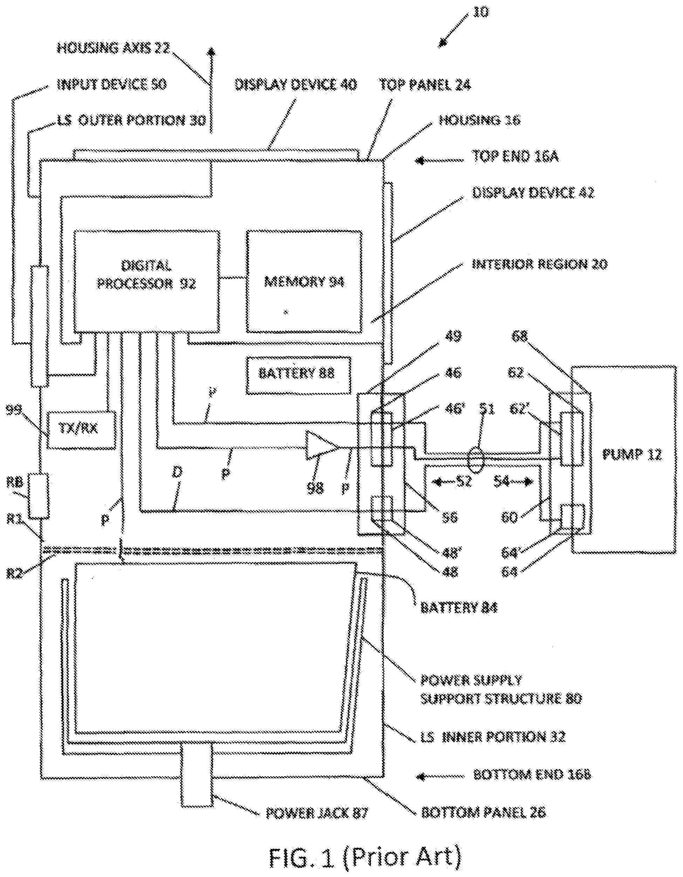

Fig. 1 illustrates a schematic view of a ventricular assist system controller according to the prior art. The control system 10 includes a housing 16 disposed about an interior region 20. Housing 16 extends along a housing axis 22 between a top end 16A and a bottom end 16B. At the top end 16A, a top panel 24 having a substantially planar outer surface, extends traverse to the house axis 22. Lateral surfaces LS of housing 16 extend between the circumferential outer boundary of top panel 24 and the circumferential outer boundary of top panel 24 and the circumferential outer boundary of bottom panel 26. In the aggregate, the lateral surfaces of housing 16 form a tube-like structure extending along axis 22, with the end panels 24 and 26 forming enclosures to the tube, or tube-like, structure; thereby enclosing the interior region 20.

The tube-like structure includes a first, or outer portion 30 (hereinafter "LS outer portion 30") opposite to a second, or inner, portion 32 (hereinafter "LS inner portion 32"). Opposing uppermost portions of the outermost surfaces of LS outer portion 30 and LS inner portion 32 are substantially planar as well as substantially parallel. However, these portions do not have to be precisely parallel and different shapes may be used in other embodiments.

A first display device 40 is disposed on the outer surface of top panel 24. A second display device 42 is disposed on the outer surface of the LS inner portion 32. The second display device 42 is optional and may be omitted from the control system 10. In an exemplary embodiment, either display device 40 or display device 42 may show the amount of charge remaining in the battery pack. In the system of Fig. 1, digital processor 92, which is located in the controller, is responsible for monitoring the charge remaining on both batteries 84 and 88 amongst its other responsibilities, such as controlling the other units of the controller. The display devices 40 and 42 also provide feedback and alarms to the patient regarding the operation of the device.

The housing 16 also includes on a lateral surface, a power port 46 and a data port 48 disposed within an input/output (I/O) connector assembly 49. An input device 50 is disposed on the outer surface of LS outer portion 30.

An elongated flexible electrical cable 51 extends from a controller end 52 to a pump end 54. The cable 51 could further include a flexible, helical-shaped strain relief segment (not shown) between the cable ends 52 and 54. A controller-end connector assembly 56 is disposed at the controller end 52, and a pump end connector assembly 60 is disposed at the pump end 54 of cable 51. The connector assembly 56 includes connector portions 46' and 48' adapted to mate with the power port 46 and the data port 48, respectively, of the I/O connector assembly 49.

The pump end connector assembly 60 similarly includes connector portions 62' and 64' adapted to mate with a pump power port 62 and a pump data port 64 of a pump I/O connector assembly 68.

The controller-end connector assembly 56 is adapted to mate with an I/O connector assembly 49 on the housing 16 and the pump-end connector assembly 60 is adapted to mate with the pump connector assembly 68 on the pump 12.

When the controller-end connector assembly 56 is connected to the I/O connector assembly 49 of the controller 10, and the pump end connector assembly 60 is connected to the pump I/O controller assembly 68 of the pump 12, the pump drive signals can pass between the power output port 46 and the pump power port 62. Data can pass between the data transfer port 48 and the pump data port 64, making available to data processor 92, the real-time impedances of the windings of the motor pump 12.

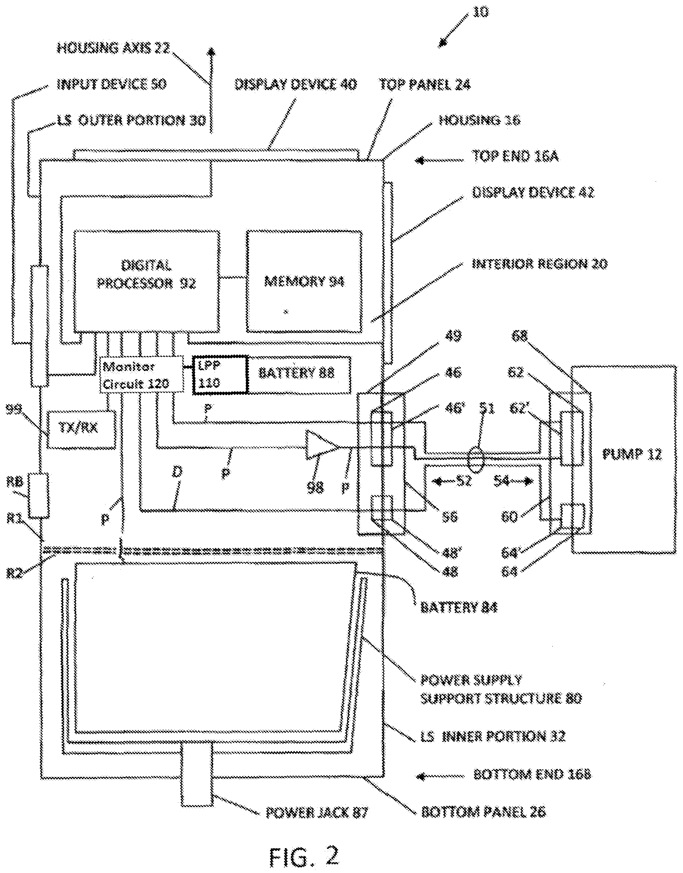

The illustrated embodiments of Figs. 1 and 2 show that the housing can be split into two cup-like components. The cup-like upper housing portion 16A has a circumferential rim R1, and the cup-like lower housing portion 16B has a circumferential rim R2. Rim R1 of the upper housing portion 16A is adapted to fit with and reversibly couple to the rim R2 of the lower housing portion 16B. A latch assembly enables the quick release of housing portion 16A from or to lower housing portion 16B, in response to the depression of a release button RB disposed on the LS outer portion 30 of upper housing portion 16A.

Fig. 1 further shows that the cup-like housing portion 16B provides electrical power for the operation of the control system 10. Housing portion 16B includes in its interior a power supply support structure 80. The support structure 80 has a cup-like form adapted to receive a battery 84 in its interior region. In some embodiments, the battery 84 is affixed to housing portion 16B and the combination is replaceable as a unit. As shown in Fig. 1, the interior of the power supply support structure 80 is geometrically keyed to the shape of the battery 84, to aid a user in replacing the battery in a fail-safe manner. In this way, the battery can only be inserted in a single, proper manner.

A secondary, or back-up, battery 88 is disposed within the interior of upper housing portion 16A, and is coupled to the various elements in control system 10 to provide back-up power to control system 10 in the event of the catastrophic failure of battery 84 or during routine replacement of battery 84 with a charged or fresh unit.

When both battery 84 and battery 88 are present, control system 10 will use battery 84 to provide power for the controller and particularly the drive electronics. When battery 84 is depleted, the controller automatically switches to the standby power source, battery 88, or adapter via power jack 87, and the depleted battery is replaced. The batteries 84 and 88 may be any suitable rechargeable battery type, such as lithium-ion, nickel-cadmium, or any other suitable composite material.

Fig. 1 also shows that support structure 80 also includes power jack 87 so that the control system 10 can be powered by an external source. The external source could also be a wall (AC) or car (DC) adapter.

The cup-like housing portion 16A houses the components that provide functional operation of control system 10, as it relates to the driving of an implanted pump 12. The housing portion 16A houses a digital processor 92 and an associated memory 94, a pump drive network 98, and the secondary battery 88.

An electrical power conductor assembly P is disposed within interior region 20. That electrical power conductor assembly P is associated with the power supply support structure 80, and couples electrical power from a power supply. That power supply could be either battery 84, an external source via power jack 87, or secondary battery 88. The electrical power conductor assembly P provides electrical power to all components of control system 10.

Additionally, the electrical power conductor assembly P provides a power drive signal line from the digital processor 92, by way of a power amplifier 98, to the electrical power output port 46, where that power drive signal can be coupled via cable 51 to the motor of pump 12.

A data conductor assembly D is also disposed within interior region 20. The data conductor assembly D provides data representing the current state of operations, including the current state of pump 12. The data received from the pump allows the digital processor 92 to determine the impedance as a function of time of the respective windings of the motor. In response to the impedance data, the digital processor 92 determines the appropriate drive power signal to be applied by way of power port 46 and cable 51 to the motor.

The input device 50 of control system 10 may take the form of a keyboard or keypad. In other embodiments, input device 50 may include a connector. In still other embodiments, the input device 50 may be both a keyboard/keypad and a connector. This input device allows for a user or administrator to change or modify any information associated with the operation of the control system 10.

Control system 10 may also contain a wired or wireless transceiver, TX/RX. The transceiver is coupled to the digital processor 92 and transmits and receives data. This allows for the control system 10 to communicate with a monitor to display highly detailed information about the control system and its usage with respect to the patient's health.

Fig. 2 shows a schematic view of a ventricular assist system according to an embodiment of the invention. This system includes additional features, such as a low power processor (LPP) 110 and monitor circuit 120. The system illustrated in Fig. 2 operates similarly to the system illustrated in Fig. 1. Like components will not be discussed further and one of ordinary skill in the art would appreciate that like components would operate the same or similarly in both systems.

Traditionally, low power processors are used in devices to allow for different power modes. LPP 110 is used for battery management purposes, relieving digital processor 92 of these duties. In prior art systems that use a digital processor to manage the charge of a battery, the battery charge typically has a shelf life of one to two months. By using the low power processor to monitor the charge of the battery, the current invention extends the shelf life of the battery charge to twelve to eighteen months.

Preferably, the LPP 110 is internal to battery 88. However, one of ordinary skill in the art would appreciate that LPP 110 could be co-located with battery 88 or the two could be adjacent and communicate via an appropriate interface. LPP 110 can be any commercially available low power processor, such as Microchip PIC24, XLP; however, any suitable processor may be used.

LPP 110 operates in either a dormant state or a wake state. The dormant state draws a small amount of current to maintain an internal timing mechanism to determine when to enter the wake state. In the wake state, LPP 110 enables several circuits, including monitor circuit 120, to determine the remaining charge of battery 84, battery 88, or both.

Monitor circuit 120 is a battery fuel gauge circuit. Generally speaking, a battery fuel gauge circuit (also known as a "gas gauge") is an integrated circuit that provides battery management by measuring current, voltage, and temperature to determine the charge of the battery. One such gas gauge is a Texas Instruments BQ20Z65 gas gauge; however, any suitable battery fuel gauge IC could perform the necessary functionality. The monitor circuit 120 also includes protection circuitry, which helps to detect over or under voltage of the batteries 84 and 88 or when the temperature of the batteries 84 and 88 exceed a certain threshold.

Monitor circuit 120 also operates in two states: default safe state and a normal operating state. The default safe state is the first state that monitor circuit 120 enters when it is powered on initially. In the default safe state, the monitor circuit 120 does not or has not detected LPP 110, and therefore signals to digital signal processor 92 that it is responsible for monitoring the charge of battery 84, battery 88, or both. In the default safe state, the digital signal processor 92, located within the controller, communicates with battery monitor circuit 120 to continually monitor the charge of battery 84, battery 88, or both. The normal operating state is entered when monitor circuit 120 detects the presence of LPP 110. In the normal operating state, the monitor circuit 120 allows itself to be shut down by LPP 110 and re-enabled when LPP 110 enters a wake state. The normal operating state allows for LPP 110 to monitor the charge of battery 84, battery 88, or both, the benefits of which will be discussed below. If the monitor circuit 120 should fail to detect LPP 110, it will revert back to default safe state.

Fig. 2 shows that monitor circuit 120 is a separate module. However, one of ordinary skill in the art would recognize that the monitor circuit could be located with LPP 110, battery 88, or battery 84. Furthermore, LPP 110, monitor circuit 120, and battery 88 could be implemented as one integrated unit.

LPP 110 communicates with both the digital processor 92 and monitor circuit 120 to determine the charge state of batteries 84 and 88. In operation, LPP 110 shuts down the monitor circuit 120 when the device is not being used in an effort to conserve the charge of both batteries 84 and 88. When the monitor circuit 120 is shut down, charge will not flow from either battery 84 or battery 88.

In one embodiment, the low power processor 'wakes up' periodically, such as hourly, daily (e.g. every 24 hours), weekly, or monthly, to check the battery. Additionally, the periodic wake up can be programmed by the user to occur at different intervals. This is different from techniques disclosed in the prior art that continuously check the battery's remaining charge. By periodically waking up for battery management, features described herein provide a low power processor that conserves charge on the batteries and allows for the charge to be used for more critical functions, such as controlling pump 12.

In an alternative embodiment, the low power processor 'wakes up' whenever an external power supply is applied. This external power supply could either be a battery 84 or a power adapter, such as a wall or car adapter, connected via power jack 87. This periodic activity by monitor circuit 120 saves power over the prior art technique of continually monitoring battery charge using a processor, thereby considerably extending shelf life (e.g. greater than 12 months) while in storage or being shipped.

For a low charge battery, such as an internal battery 88, this ability to totally shut-down may be crucial. Furthermore, this embodiment may also be used in conjunction with the low power processor waking up periodically. In other words, the low power processor may wake up both periodically and when an external power supply is connected.

When LPP 110 wakes up, it activates the monitor circuit 120. The monitoring circuit 120 then takes the necessary steps to determine the charge state of the battery 84, battery 88, or both, by sampling the current, voltage, and/or temperature associated with the battery. Based on the state information of the battery, the monitor circuit 120 displays the current charge via either display device 40 or display device 42. For example, if the monitoring circuit 120 determines that the remaining charge is below a predetermined threshold, the display devices 40 and/or 42 may display the charge in addition to creating a user alert that the battery 88 should be recharged. This alarm may last a predetermined amount of time, and then turn off to conserve battery charge.

When the device is manufactured it is set to a default state. This includes monitor circuit 120 being configured to a default safe state. As discussed above, in this state monitor circuit 120 signals to digital processor 92 to monitor the charge of the battery, which it does by communicating with monitor circuit 120. Once LPP 110 is detected, monitor circuit 120 will enter the normal operating state, which allows monitor circuit 120 to be shut down by LPP 110 and re-enabled when LPP 110 enters a wake state. The normal operating state also permits LPP 110 to communicate with monitor circuit 120 to determine the charge of the connected batteries. If the monitor circuit 120 should fail to detect LPP 110 or a fault is detected with respect to LPP 110, it will revert back to the default safe state.

When the device is stored for an extended period of time or shipped, it is put into a dormant state. In this state, LPP 110 enters a dormant mode in which power to the other circuits is stopped. While in this dormant state, LPP 110 will periodically enter a wake state in which it will provide power to a plurality of circuits, including the monitor circuit 120, such that it can determine the charge remaining on battery 84, battery 88, or both. This helps preserve the charge in the batteries during the extended period of not being used.

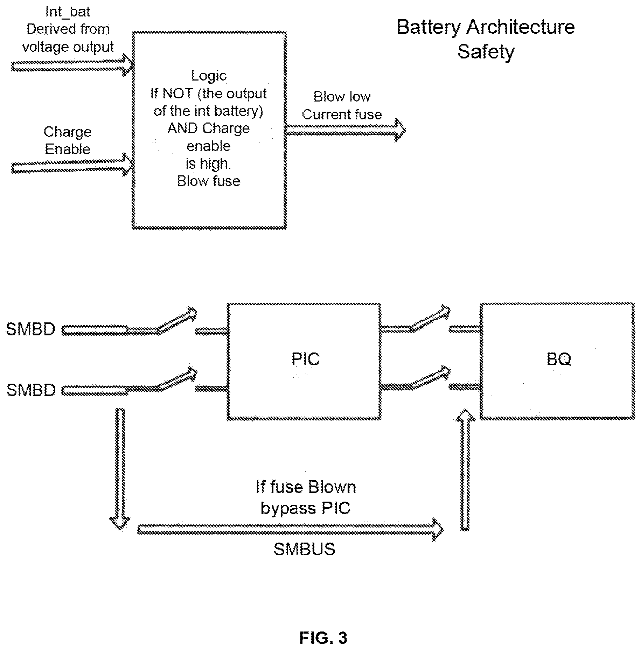

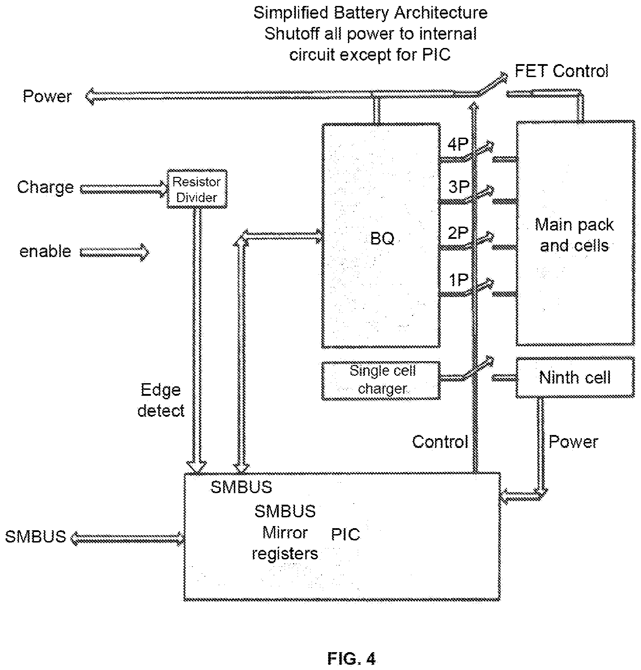

Another feature according to an embodiment of the invention is a safety override circuit as illustrated by Figs. 3 and 4. The safety override circuit is a redundancy component that provides power in the situation where LPP 110 fails to wake-up. This would ensure that power flows from either battery 84 or battery 88 even in the circumstance where LPP 110 fails. For a device such as a controller for a ventricular assist system, this ensures that a charge will flow and the critical life saving functions being performed by pump 12 are interrupted only minimally, if at all. Additionally, it is important to alert a user or administrator of a problem. Therefore, if LPP 110 fails, an error message can be displayed on either display interface 40 or display interface 42 to indicate a fault and the type of fault.

In one embodiment, LPP 110 is connected to an analog switch. When LPP 110 wakes up, the switch is toggled and LPP 110, in combination with monitor circuit 120, manages the flow of charge from the battery. If LPP 110 fails to wake up, the analog switch is not toggled and a fault is detected. Faults may be detected for reasons other than LPP 110 not waking up, such as the switch not operating properly.

If the switch is not toggled, LPP 110 is bypassed and digital processor 92 becomes responsible for power management. Digital processor 92 communicates with monitor circuit 120 in order to properly manage power consumption of the device. This allows charge to flow from either battery 84 or battery 88, thereby providing the power necessary to drive electronics for the pump and provides drive and control signals to the pump.

When LPP 110 is bypassed, digital processor 92 communicates with monitor circuit 120. This has the effect of leaving the monitor circuit 120 in a constant state of being powered on. While this has the undesirable effect of constantly drawing power from the batteries, it at least ensures that power will flow and the device will not fail catastrophically.

In an alternative embodiment, such as when an external power supply is applied to the control system 10, the charge signal will go high and cause LPP 110 to wake-up. As shown in Fig. 4, if LPP 110 wakes up, it applies voltage to its output pins and charge is allowed to flow from the battery.

However, in the case of a fault, LPP 110 may not wakeup. Consequently, as shown by Fig. 4, the output FETS will not be enabled. After some time, the control system 10 will wake up from having external power applied to it, and assert the charge enable line. The control system 10 will detect that the internal battery pack 88 is not outputting voltage and the system management bus is not communicating. The presence of the charge enable line and absence of output voltage inside the pack, will cause a fuse to blow as shown in Fig. 3. This will permanently put the pack into "always on" mode. The digital processor 92 will communicate directly with the monitor circuit 120, and the system 10 will not be able to go into a long term dormant mode.

Although the invention herein has been described with reference to particular embodiments, it is to be understood that these embodiments are merely illustrative of the principles and applications of the present invention. It is therefore to be understood that numerous modifications may be made to the illustrative embodiments and that other arrangements may be devised without departing from the scope of the present invention as defined by the appended claims.

For example, the smart battery pack comprising a low power processor has been described in the context of the HeartWare Ventricular Assist System, but one of ordinary skill in the art could readily recognize its advantages in mobile devices, such as smart phones, laptops, and tablet computers. Likewise the smart battery pack of the present invention could be implemented in digital cameras, portable speakers, or any other suitable electronics equipment that has an extended dormant period.

## Claims

1. A method for monitoring a charge of a battery (84) in a device (10), comprising:
providing a low power processor (110) having a wake state and a dormant state, the low power processor (110) configured to periodically change from the dormant state to the wake state; wherein the dormant state draws a small amount of current to maintain an internal timing mechanism to determine when to enter the wake state; and wherein in the wake state, the low power processor enables several circuits, including a battery monitor circuit (120), to determine the remaining charge of the battery (84); and
periodically enabling the battery monitor circuit (120) to determine the charge of the battery (84), the low power processor (110) enabling the battery monitor circuit (120) when the low power processor (110) is in the wake state;
wherein the battery monitor circuit (120) has a default safe state in which a digital processor (92) enables the battery monitor circuit (120), wherein in the default safe state, the battery monitor circuit does not or has not detected the low power processor and signals to the digital processor that it is responsible for monitoring the charge of the battery, and a normal operating state in which the low power processor (110) periodically enables the battery monitor circuit (120), wherein the normal operating state allows for the low power processor to monitor the charge of the battery, the battery monitor circuit (120) switching from the default safe state to the normal operating state when the low power processor (110) is detected,
wherein the digital processor (92) is different than the low power processor (110).

2. The method of claim 1, wherein the battery monitor circuit (120) switches from the normal operating state to the default safe state when the device (10) detects a fault in the low power processor (110).

3. The method of claim 1, wherein determining the charge of the battery (84) further comprises detecting the charge of at least two batteries (84, 88).

4. The method of claim 3, wherein at least one of the two batteries (84, 88) is removable from the device (10).

5. The method of claim 1, further comprising displaying the determined charge on a display (40) on the device (10).

6. The method of claim 1, further comprising generating an alarm when the determined charge is below a threshold.

7. The method of claim 1, further comprising displaying a fault message if the low power processor (110) fails to wake-up.

## Patentansprüche

1. Verfahren zum Überwachen eines Batterieladezustand (84) in einer Vorrichtung (10), Folgendes umfassend:
Bereitstellen eines Niederleistungsprozessors (110), der einen Wachzustand und einen Ruhezustand aufweist, wobei der Niederleistungsprozessor (110) konfiguriert ist, um periodisch von dem Ruhezustand in den Wachzustand zu wechseln; wobei der Ruhezustand eine kleine Strommenge zieht, um einen internen Zeiteinstellungsmechanismus aufrechtzuerhalten, um zu bestimmen, wann in den Wachzustand eingetreten werden soll; und wobei in dem Wachzustand der Niederleistungsprozessor mehrere Schaltungen, einschließlich einer Batterieüberwachungsschaltung (120), aktiviert, um den verbleibenden Batterieladezustand (84) zu bestimmen; und
periodisches Aktivieren der Batterieüberwachungsschaltung (120), um die Batterieladezustand (84) zu bestimmen, wobei der Niederleistungsprozessor (110) die Batterieüberwachungsschaltung (120) aktiviert, wenn sich der Niederleistungsprozessor (110) in dem Wachzustand befindet;
wobei die Batterieüberwachungsschaltung (120) einen standardmäßigen sicheren Zustand aufweist, in dem ein digitaler Prozessor (92) die Batterieüberwachungsschaltung (120) aktiviert, wobei in dem standardmäßigen sicheren Zustand die Batterieüberwachungsschaltung den Niederleistungsprozessor nicht erfasst oder nicht erfasst hat, und an den digitalen Prozessor signalisiert, dass er für das Überwachen des Batterieladezustandes verantwortlich ist, und einen normalen Betriebszustand aufweist, in dem der Niederleistungsprozessor (110) periodisch die Batterieüberwachungsschaltung (120) aktiviert, wobei der normale Betriebszustand es dem Niederleistungsprozessor ermöglicht, den Batterieladezustand zu überwachen, wobei die Batterieüberwachungsschaltung (120) von dem standardmäßigen sicheren Zustand in den normalen Betriebszustand schaltet, wenn der Niederleistungsprozessor (110) erfasst wird,
wobei sich der digitale Prozessor (92) von dem Niederleistungsprozessor (110) unterscheidet.

2. Verfahren nach Anspruch 1, wobei die Batterieüberwachungsschaltung (120) von dem normalen Betriebszustand in den standardmäßigen sicheren Zustand schaltet, wenn die Vorrichtung (10) einen Fehler in dem Niederleistungsprozessor (110) erfasst.

3. Verfahren nach Anspruch 1, wobei das Bestimmen des Batterieladezustandes (84) ferner das Erfassen des Ladezustandes von wenigstens zwei Batterien (84, 88) umfasst.

4. Verfahren nach Anspruch 3, wobei wenigstens eine der beiden Batterien (84, 88) von der Vorrichtung (10) entfernbar ist.

5. Verfahren nach Anspruch 1, ferner umfassend ein Anzeigen des bestimmten Ladezustandes auf einer Anzeige (40) auf der Vorrichtung (10).

6. Verfahren nach Anspruch 1, ferner umfassend ein Erzeugen eines Alarms, wenn der bestimmte Ladezustand unter einem Schwellenwert liegt.

7. Verfahren nach Anspruch 1, ferner umfassend das Anzeigen einer Fehlermeldung, wenn der Niederleistungsprozessor (110) nicht aufwacht.

## Revendications

1. Procédé de surveillance d'une charge d'une batterie (84) dans un dispositif (10), comprenant :
la fourniture d'un processeur basse consommation (110) ayant un état éveillé et un état dormant, le processeur basse consommation (110) étant configuré pour passer périodiquement de l'état dormant à l'état éveillé ; l'état dormant débitant une petite quantité de courant pour maintenir un mécanisme de synchronisation interne afin de déterminer le moment où il convient d'entrer dans l'état éveillé ; et à l'état éveillé, le processeur basse consommation activant plusieurs circuits, y compris un circuit de surveillance de batterie (120), pour déterminer la charge restante de la batterie (84) ; et
l'activation périodique du circuit de surveillance de batterie (120) pour déterminer la charge de la batterie (84), le processeur basse consommation (110) activant le circuit de surveillance de batterie (120) lorsque le processeur basse consommation (110) est dans l'état éveillé ;
le circuit de surveillance de batterie (120) ayant un état de sûreté par défaut dans lequel un processeur numérique (92) active le circuit de surveillance de batterie (120), dans l'état de sûreté par défaut, le circuit de surveillance de batterie ne détectant pas ou n'ayant pas détecté le processeur basse consommation et signale au processeur numérique qu'il est responsable de la surveillance de la charge de la batterie, et un état de fonctionnement normal dans lequel le processeur basse consommation (110) active périodiquement le circuit de surveillance de batterie (120), l'état de fonctionnement normal permettant au processeur basse consommation de surveiller la charge de la batterie, le circuit de surveillance de batterie (120) passant de l'état de sûreté par défaut à l'état de fonctionnement normal lorsque le processeur basse consommation (110) est détecté,
le processeur numérique (92) étant différent du processeur basse consommation (110).

2. Procédé selon la revendication 1, dans lequel le circuit de surveillance de batterie (120) passe de l'état de fonctionnement normal à l'état de sûreté par défaut lorsque le dispositif (10) détecte une anomalie dans le processeur basse consommation (110).

3. Procédé selon la revendication 1, dans lequel la détermination de la charge de la batterie (84) comprend en outre la détection de la charge d'au moins deux batteries (84, 88).

4. Procédé selon la revendication 3, dans lequel au moins l'une des deux batteries (84, 88) est amovible du dispositif (10).

5. Procédé selon la revendication 1, comprenant en outre l'affichage de la charge déterminée sur un moniteur (40) sur le dispositif (10).

6. Procédé selon la revendication 1, comprenant en outre la génération d'une alarme lorsque la charge déterminée est inférieure à un seuil.

7. Procédé selon la revendication 1, comprenant en outre l'affichage d'un message d'anomalie si le processeur basse consommation (110) ne sort pas de l'état de veille.
